(19) Europäisches Patentamt

European Patent Office

Office européen des brevets

(11) EP 1 394 974 A2

(12) EUROPEAN PATENT APPLICATION

(43) Date of publication:
03.03.2004 Bulletin 2004/10

(51) Int Cl.7: H04J 3/06

(21) Application number: 03102552.1

(22) Date of filing: 15.08.2003

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 30.08.2002 GB 0220114
12.12.2002 GB 0229048

(71) Applicant: Zarlink Semiconductor Limited
Swindon, Wiltshire SN2 2QW (GB)

(72) Inventors:
• Scott, Martin Raymond
  Perranporth, Cornwall TR6 0HX (GB)
• Frost, Timothy Michael Edmund
  Plymouth, Devon PL6 7QE (GB)
• Faithorn, Nicholas
  Tavistock, Devon PL19 9RD (GB)

(74) Representative: Asquith, Julian Peter
Marks & Clerk,
4220 Nash Court,
Oxford Business Park South
Oxford OX4 2RU (GB)

(54) **Adaptive clock recovery in packet networks**

(57)    A method of recovering a clock signal for a TDM output from packets of TDM data which have been transmitted over a packet network, comprises

providing a packet buffer to store incoming packets after transmission over the packet network,

maintaining a packet count which is incremented as packets arrive at the packet buffer, and decremented each time a packet leaves the packet buffer, and

sampling the packet count and controlling the clock frequency of the TDM output on the basis of the sampled packet count.

Figure 2

**Description**

The invention relates to the recovery of clock signals for a TDM output from packets of TDM data which have been transmitted over a packet network.

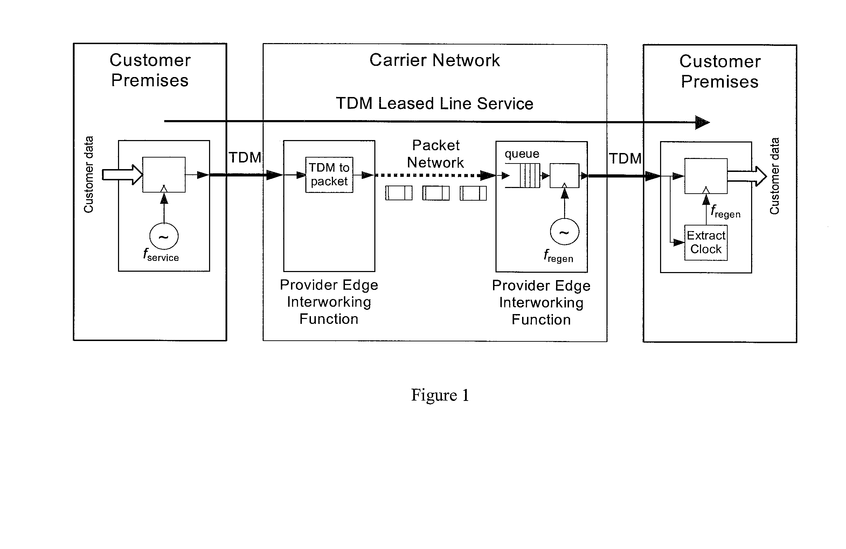

TDM links are synchronous circuits, with a constant bit rate governed by the service clock $f_{service}$. With a packet network the connection between the ingress and egress frequency is broken, since packets are discontinuous in time. From Figure 1, the TDM service frequency $f_{service}$ at the customer premises must be exactly reproduced at the egress of the packet network ($f_{regen}$). The consequence of a long-term mismatch in frequency is that the queue at the egress of the packet network will either fill up or empty, depending on whether the regenerated clock is slower or faster than the original. This will cause loss of data and degradation of the service.

The relevant standards on circuit emulation services over ATM, ITU standard I.363.1 and ATM Forum standard af-vtoa-0078 refer to the concept of adaptive clock recovery in general terms.

This invention seeks to provide an adaptive method for recovering the original service clock frequency from the arrival rate of packets across the network.

According to the invention there is provided a method of recovering a clock signal, and a reference clock recovery system, as set out in the accompanying claims.

Embodiments of the invention will now be more particularly described, by way of example only, with reference to the accompanying drawings, in which:

Figure 1 is a schematic diagram showing a leased line TDM service being carried across a packet network; and

Figure 2 is a schematic diagram showing a packet count clock recovery method in accordance with an embodiment of the invention.

In Figure 1, the rate of transmission of packets from the source device is isochronous and determined by $f_{service}$. However, the rate of packet arrival at the destination device is perturbed by the intervening packet network. Packets will typically arrive in bursts separated by varying amounts of delay. The delay between successive packets and bursts will vary depending on the amount of traffic in the network. The characteristics of the network are non-deterministic, but over the long term the rate of arrival at the destination will equal the rate of departure at the source (assuming no lost or duplicate packets).

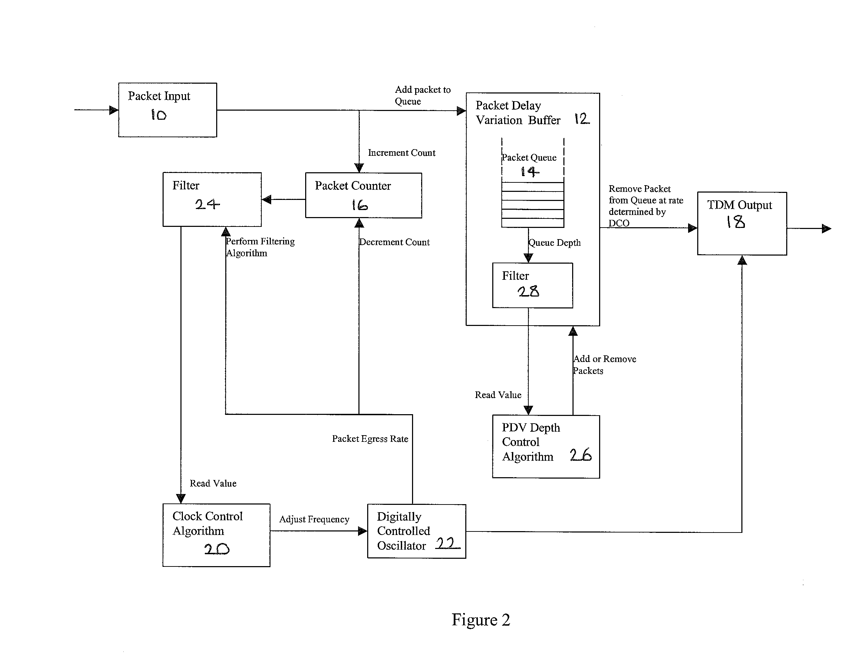

The TDM output at the destination is isochronous and determined by $f_{regen}$. This is provided by the Digitally Controlled Oscillator (DCO) (22) in Figure 2. The output is supplied from a Packet Delay Variation (PDV) Buffer (12). If the buffer has zero packets in it when the TDM output requires to transmit then an underrun will occur, which is undesirable. In order to minimise underrun events it is necessary to build up the PDV buffer (12) so that it contains sufficient packets to supply the TDM output for the majority of inter packet delays. However, the PDV buffer (12) cannot be made arbitrarily large because this directly increases the end to end latency which, in general, is required to be as low as possible, the maximum tolerable latency being dependent on the application. For example, voice requires lower latency than data.

Thus the optimal PDV Buffer depth depends upon network conditions and application. The clock recovery method described here allows the buffer depth to be varied independently of the clock recovery mechanism. This allows the clock recovery to stabilise prior to setting up the PDV Buffer, and allows the buffer to be changed during operation to match any underlying shift in network characteristics.

When packets arrive at the Packet Input (10) they are placed into the PDV Buffer (12) in a Queue (14). They also cause the Packet Count in Packet Counter (16) to be incremented. The Packet Count will increment by one for each packet received. The rate at which packets are received is determined by the frequency of the source TDM clock $f_{service}$. The rate at which the PDV Buffer (12) is emptied is determined by the frequency of the destination TDM clock $f_{regen}$. The Packet Count is decremented by one each time that the DCO output indicates that a packet has been transmitted from the TDM output (18). Note that if the PDV Buffer (12) is empty when the TDM output (18) requests a packet, an underrun packet will be supplied to the TDM output (18). In this case the Packet Count will still be decremented. Therefore the value in the Packet Counter can be positive or negative.

Hence, given an ideal fixed delay packet network, the value of the Packet Count will increase if $f_{service}$ exceeds $f_{regen}$, will decrease if $f_{regen}$ exceeds $f_{service}$, and will remain constant if the frequencies are identical.

Therefore a Clock Control Algorithm (20) can sample this value at a fixed interval (the Clock Control Interval), perform a calculation to determine a correction that can be applied in order to converge the local frequency to the source frequency, and write the new local frequency value to a DCO (22).

With a real network the value of the Packet Count fluctuates due to the burst nature of the incoming packet stream. This causes fluctuations in the recovered clock. Therefore a filter function (24) is provided on the device which provides the following benefits:

- reduces the workload of the Clock Control Algorithm (which may be implemented by an external CPU) in terms of numerical processing
- reduces the workload of the Clock Control Algorithm by allowing the Clock Control Interval to be increased
- reduces fluctuations in the recovered clock

In this embodiment the filter (24) is a first order low pass filter with the following difference equation that is simple to implement in hardware without requiring any dividers or multipliers:

$$Y_n = Y_{n-1} + (X_n - Y_{n-1})/2^P \qquad \text{(Equation 1)}$$

Where :

$Y_n$ is the Filter Output
$X_n$ is the Packet Count
P is a programmable parameter that determines the time constant of the filter
n is the sample number that increments each time that a packet is taken from the PDV Buffer

The Clock Control Algorithm (20) reads the Filter Output and determines the correction required to stabilise the Packet Count, and writes the required Frequency to the DCO.
A simple first order Clock Control Algorithm is given by the following difference equation:

$$F_m = \alpha F_{m-1} + \beta Y_m$$

Where:

$F_m$ is the Frequency to be written to the DCO
$\alpha$, $\beta$ are constants that determine the time constant
$F_{m-1}$ is the Current DCO Frequency
$Y_m$ is the Filter output
m is the sample number that increments each time the Clock Control Algorithm reads the Filter Output

The time constant is selected to track long term drift in $f_{service}$ but reject short term variation due to packet delay variations.
The PDV Depth Control Algorithm (26) should make relatively infrequent adjustments to the PDV Buffer (12) which may be based on any of the following:

- Filtered Depth reading of queue depth provided by Depth Filter (28), which may be of the type described by Equation (2)
- Underrun events (indicating the Queue is too small)
- Maximum and Minimum Depth readings
- Network Delay Measurements (for example obtained by a network "ping" utility) The Minimum & Maximum queue depth values are reset to the current Queue Depth when they are read by the PDV Buffer Depth Control Algorithm (26), and are then adjusted whenever the Packet Queue Depth is altered.

Alternative Filter algorithms may be used.
Alternative Clock Control Algorithms may be used e.g. 2nd and higher order, fuzzy logic, neural networks, and self-tuning algorithms that vary parameters such as the time constant or Clock Control Interval over time.
An internal or external CPU may be used for the Clock Control & Depth Control Algorithms
Sequence numbers may be used within the packets, in which case the Packet Count increment can be made to take into account lost packets. This improves the performance of the clock recovery method in networks with a significant percentage of lost packets. In this case, when a packet arrives the following algorithm may be applied to determine the Packet Count increment. (Wraparound must also be detected and dealt with appropriately).

If $S_k > S_{k-1}$ then increment = $S_k - S_{k-1}$
Else increment = 0
Where :

$S_k$ is the sequence number of the received packet

$S_{k-1}$ is the sequence number of the previous received packet

Byte or Bit resolution rather than Packet resolution may be used, where the Counter value represents Bytes or Bits rather than Packets. In this case, when a packet arrives, the Counter is incremented by the number of payload bytes or bits that it contains, whereas the Counter is decremented by one whenever the DCO output indicates that a byte or bit has been transmitted by the TDM output.

The method has application in timing recovery over packet based systems or other asynchronous systems. A typical application of the method described above is in emulation of TDM (time division multiplexed) circuits across a packet network, such as Ethernet, ATM or IP. Circuit emulation may be used to support the provision of leased line services to customers using legacy TDM equipment. For example, Figure 1 shows a leased line TDM service being carried across a packet network. The advantages are that a carrier can upgrade to a packet switched network, whilst still maintaining their existing TDM business.

The clock recovery method described above provides the following advantages:

1. The method makes use of all of the incoming data packets at the destination device to converge average packet egress rate to average packet ingress rate.

2. No special timing packets or information is required.

3. No expensive Clock Generation Circuits are required (such as oven controlled crystal oscillators).

4. A Packet Counter is maintained that allows the difference between the rate at which packets are received at the packet input and the rate at which they are transmitted from the TDM output to be monitored.

5. The Packet Counter value is operated on by packet ingress and packet egress events.

6. The Packet Counter value is filtered at an appropriate interval.

7. The filtered Packet Counter value is used by a Clock Control Algorithm to adjust the egress packet rate of the device.

8. The separation of the filter from the Clock Recovery Algorithm allows the Clock Control Algorithm to operate at a much slower rate than the filter. So that, for example, a high speed filter could be implemented in Hardware and a low speed Clock Control Algorithm with an external CPU. This confers significant benefits, such as flexibility, reduction of development risk, ease of optimising the solution for a specific environment etc.

9. The method allows packets to be deleted from the PDV Buffer and dummy packets to be inserted into the PDV Buffer in order to adjust the device latency. This does not affect the counter value mentioned above.

10. The PDV Buffer Depth is filtered at an appropriate interval.

11. Minimum & Maximum PDV Buffer Depth values are maintained

12. The filtered PDV Buffer Depth, and Minimum & Maximum PDV Buffer Depth values may be used by a Buffer Depth Control Algorithm which may run at a much slower rate than the rate at which the filter is updating.

13. The PDV Buffer depth can to be varied independently of the clock recovery mechanism. This allows the clock recovery to stabilise prior to setting up the PDV Buffer, and allows the buffer to be changed during operation to match any underlying shift in network characteristics.

It is also possible for the clock control algorithm 20 to perform "phase locking".

In this case, the method provides automatic adjustment of the packet egress rate to maintain the phase relationship between the packet ingress rate and the packet egress rate. This maintains the average depth of the PDV Buffer 12 at any desired value. The clock recovery method will lock to the phase of the source frequency, this means that it will ensure that the number of packets transmitted will equal the number of packets received in order to maintain a fixed average depth of packets in the PDV Buffer 12.

If the Clock Control Algorithm 20 controls the DCO Frequency to maintain a constant value of Packet Count, then the local frequency will be phase locked to the remote frequency, which will maintain a constant number of packets in the PDV Buffer 12. This offers an advantage over frequency locking because with the latter, any lag in tracking the source frequency, eg during a prolonged drift, may result in a deviation in the average PDV Buffer depth from the desired value.

A Clock Control Algorithm that will perform phase locking is given by the following difference equation:

$$F_m = F_{m-1} + G1(Y_m - Y_{m-1}) + G2(Y_m - \text{Offset}) \qquad \text{Equation (2)}$$

Where:

$F_m$ is the Frequency to be written to the DCO
G1, G2 are constants that determine the dynamic behaviour
$F_{m-1}$ is the Current DCO Frequency
$Y_m$ is the Filter output
Offset is a constant that may be used to build a PDV Buffer, or maintain it at a particular value
m is the sample number that increments each time the Clock Control Algorithm reads the Filter Output

The constants G1 and G2 determine the frequency response of the system and are selected to track long term drift in $f_{\text{service}}$ but reject short-term variation due to packet delay variations.

G2 determines the rate at which the frequency will be altered in order to drive the PDV Buffer 12 to the desired depth.

Offset may be used to build the required average operating depth of PDV Buffer 12 in the following way: if initially the Packet Input is disabled, the PDV Buffer 12 is empty, and the Packet Counter 16 is zero, then when the Packet Input is enabled the Algorithm (Equation (20)) will build an average PDV Buffer depth equal to the Offset value and stabilise at this value.

Similarly, Offset can also be used during operation to adjust the average PDV Buffer depth to a new value, for example if the network conditions change.

Alternatively the PDV Buffer 12 can be established by some other means, and the Packet Count can then be initialised to the Offset value.

## Claims

1. A method of recovering a clock signal for a TDM output from packets of TDM data which have been transmitted over a packet network, the method comprising:

    providing a packet buffer to store incoming packets after transmission over the packet network,
    maintaining a packet count which is incremented as packets arrive at the packet buffer, and decremented each time a packet leaves the packet buffer, and
    sampling the packet count and controlling the clock frequency of the TDM output on the basis of the sampled packet count.

2. A method as claimed in claim 1, which further comprises:

    sampling the packet count at a fixed interval,
    performing a calculation to determine the source frequency of a TDM clock at the source of the packets, and
    writing a new local frequency value to a digitally controlled oscillator which controls the clock frequency of said TDM output.

3. A method as claimed in claim 1 or 2, which further comprises filtering the value of the packet count before sampling the packet count.

4. A method as claimed in claim 3 wherein the filtering is carried out using a first order low pass filter.

5. A method as claimed in any preceding claim which further comprises:

making adjustments to the packet buffer, by adding or removing packets, based on at least a filtered reading of the depth of the packet buffer.

6. A method as claimed in any preceding claim, which comprises controlling said clock frequency so as to maintain the average depth of the packet buffer at a predetermined value.

7. A method as claimed in claim 6, which comprises performing the following algorithm to determine said clock frequency:

$$F_m = F_{m-1} + G1(Y_m - Y_{m-1}) + G2(Y_m - \text{Offset})$$

where:

$F_m$ and $F_{m-1}$ are the new and previous clock frequencies respectively;
G1 and G2 are constants;
$Y_m$ and $Y_{m-1}$ are new and previous filtered packet count values; and
Offset is a constant that represents the desired depth of the packet buffer.

8. A reference clock recovery system, for recovering a clock signal for a TDM output from packets of TDM data which have been transmitted over a packet network, the system comprising:

a packet buffer for storing incoming packets after transmission over the packet network,
a packet counter which maintains a packet count which is incremented as packets arrive at the packet buffer, and decremented each time a packet leaves the packet buffer, and
a clock control device which samples the packet count value and controls the clock frequency of the TDM output on the basis of the sampled packet count.

9. A reference clock recovery system as claimed in claim 8, which further comprises a digitally controlled oscillator which controls the clock frequency of said TDM output,
and wherein the clock control device performs a clock control algorithm which determines the source frequency of a TDM clock at the source of the packets, and writes a new local frequency value to the digitally controlled oscillator so as to control the clock frequency of said TDM output.

10. A reference clock recovery system as claimed in claim 8 or 9, which further comprises a packet counter filter arranged to filter the value of the packet count before the value of the packet count is sampled by the clock control device.

11. A reference clock recovery system which further comprises a buffer depth control device arranged to make adjustments to the packet buffer, by adding or removing packets, based on at least a filtered reading of the depth of the packet buffer.

12. A reference clock recovery system as claimed in any of claims 8 to 11, wherein said clock control device is arranged to control said clock frequency so as to maintain the average depth of the packet buffer at a predetermined value.

13. A reference clock recovery system as claimed in claim 12, wherein said clock control device performs the following algorithm in order to control said clock frequency:

$$F_m = F_{m-1} + G1(Y_m - Y_{m-1}) + G2(Y_m - \text{Offset})$$

where:

$F_m$ and $F_{m-1}$ are the new and previous clock frequencies respectively;
G1 and G2 are constants;
$Y_m$ and $Y_{m-1}$ are new and previous filtered packet count values; and
Offset is a constant that represents the desired depth of the packet buffer.

Figure 1

EP 1 394 974 A2

Packet Input
10

Add packet to Queue

Packet Delay Variation Buffer 12

Packet Queue
14

Increment Count

Filter
24

Packet Counter
16

Remove Packet from Queue at rate determined by DCO

TDM Output
18

Perform Filtering Algorithm

Decrement Count

Queue Depth

Filter
28

Add or Remove Packets

Read Value

Packet Egress Rate

PDV Depth Control Algorithm 26

Read Value

Clock Control Algorithm 20

Adjust Frequency

Digitally Controlled Oscillator 22

Figure 2